# EUROPEAN PATENT SPECIFICATION

(11) **EP 2 254 398 B1**
(45) Date of publication and mention of the grant of the patent: **08.02.2012**
(21) Application number: 10163136.4
(22) Date of filing: 18.05.2010
(51) Int. Cl.: H05K 7/14

(54) **Support member of circuit board**
Halteelement für Leiterplatte
Elément de support de carte de circuit imprimé

(30) Priority: 18.05.2009 JP 2009119416
(43) Date of publication of application: 24.11.2010
(73) Proprietor: Funai Electric Co., Ltd., Daito-shi, Osaka 574-0013 (JP)
(72) Inventor: Shingin, Yasuhiro, Daito-shi Osaka 574-0013 (JP); Yamagiwa, Daisuke, Daito-shi Osaka 574-0013 (JP)
(74) Representative: Grünecker, Kinkeldey, Stockmair & Schwanhäusser

(56) References cited:
- US-A- 3 733 655
- US-A- 4 970 761

## Description

### BACKGROUND OF THE INVENTION

### Field of the Invention

The present invention relates to a support member of a circuit board, and more particularly, it relates to a support member of a circuit board capable of holding a plurality of circuit boards at a prescribed interval.

### Description of the Background Art

A support member of a circuit board or the like capable of holding a plurality of circuit boards at a prescribed interval is known in general, as disclosed in each of Japanese Patent Laying-Open No. 2-76297 (1990) and Japanese Utility Model Laying-Open No. 1-143185 (1989), for example.

The aforementioned Japanese Patent Laying-Open No. 2-76297 discloses a spacer for a printed board so formed that a plurality of printed boards (circuit boards) can be stacked and held at a prescribed interval. This spacer for a printed board is formed to be mounted on the printed board by fitting a male side engaging portion protruding to a first side of a shaft portion of the spacer into an opening (hole) provided on the printed boards. A female side engaging portion concaved inward is provided on a second side of the shaft portion of the spacer, and hence the male side engaging portion of the first spacer can be detachably engaged with the female side engaging portion of the second spacer. Thus, the spacers are coupled with each other in an axial direction (a direction where the printed board is stacked) in a state where the spacer is mounted on the printed board, whereby the plurality of printed boards can be stacked and held through the spacers.

The aforementioned Japanese Utility Model Laying-Open No. 1-143185 discloses a stacked and fixed structure of printed boards through column supports (spacer members) in which a plurality of the printed boards (circuit boards) can be stacked and held at a prescribed interval. In this stacking and fixed structure of printed boards, a pair of support pieces (flanged projecting portions) are formed on an outer circumferential surface of the column support in a column shape along an axial direction of the column support at an interval corresponding to the thickness of the printed board while a plurality of the pair of support pieces are provided along the axial direction of the column support at a prescribed interval. Thus, the column support is so formed that one printed board can be sandwiched between the pair of support pieces in a state where the column support is inserted into an opening provided on the printed board. Further, the column support is so formed that the plurality of printed boards can be stacked and held at the prescribed interval by sandwiching the printed board between another pair of support pieces provided at the prescribed interval in this state. The opening provided on the printed board is formed by notching en edge of the printed board in a horseshoe shape and is so formed that the inner diameter of the opening is smaller than the outer diameter of the support piece (flange). Therefore, the printed board is sandwiched between the support pieces (flanges) by sliding a portion between the pair of support pieces, of the column support along an in-plane direction of the printed board to be inserted into the opening when the column support is fixed on the printed board.

In the spacer for a printed board disclosed in the aforementioned Japanese Patent Laying-Open No. 2-76297, however, the spacer mounted on one printed board must be sequentially coupled in the axial direction to be stacked when stacking and holding the plurality of printed boards, and therefore, work for coupling a plurality of the spacers must be repeated. Further, when separating the stacked printed boards one by one from each other, the engagement between the coupled spacers must be sequentially canceled to separate the printed boards from each other, and therefore a coupling state between the spacers must be repeatedly canceled. Thus, an engagement (coupling) or an engagement state between the spacers must be repeatedly canceled in assembling work in stacking the printed board (circuit board) or in work in separating the stacked printed boards from each other, and therefore work is disadvantageously complicated.

In the stacked and fixed structure of printed boards through column supports disclosed in the aforementioned Japanese Utility Model Laying-Open No. 1-143185, the column support is slid in the in-plane direction of the printed board to be inserted into the opening (notch in a horseshoe shape) provided on the edge of the printed board, and therefore the opening of the printed board can be provided only in the vicinity of the edge of the printed board. In other words, the column support can conceivably support the printed board only in the vicinity of the edge of the printed board. Thus, when stacking the printed board with large plane area, for example, the column support can support the printed board only in the vicinity of the edge of the printed board, and therefore the central part of the printed board may conceivably be not reliably supported. Consequently, the column support cannot disadvantageously reliably hold the printed board (circuit board).

Document US 3733655 discloses a support member of a circuit board comprising:
a columnar portion capable of reducing an outer shape by elastic deformation and capable of passing through an opening provided on the circuit board; and
a plurality of projecting portions provided to protrude from an outer circumferential surface of the columnar portion, arranged at a prescribed interval in an axial direction of the columnar portion, and passing through the opening of the circuit board when the columnar portion is elastically deformed to reduce the outer shape, and
the circuit board is arranged between the projecting portions adjacent in the axial direction of the columnar portion in a state where the columnar portion passes through the opening of the circuit board, so that a plurality of the circuit boards are held at the prescribed interval along the axial direction of the columnar portion.

The projecting portions are arranged in pairs, each pair meant to support one circuit board. The outer surfaces of each projecting portion in each pair are inclined in opposite directions with respect to the central axis of the support member and they have a rounded shape.

### SUMMARY OF THE INVENTION

The present invention has been proposed in order to solve the aforementioned problems, and an object of the present invention is to provide a support member of a circuit board capable of improving workability and capable of reliably holding the circuit board.

A support member of a circuit board according to an aspect of the present invention is presented in claim 1.

The support member of a circuit board according to the aspect of the present invention, as hereinabove described, comprises the columnar portion capable of passing through the opening provided on the circuit board, and the plurality of projecting portions arranged at the prescribed interval in the axial direction of the columnar portion and passing through the opening of the circuit board, whereby the circuit board is arranged between the projecting portions adjacent in the axial direction of the columnar portion in a state where the columnar portion passes through the opening of the circuit board, so that the plurality of circuit boards are held at the prescribed interval along the axial direction of the columnar portion. Hence, a worker can stack and fix the individual circuit boards vertically simply by inserting the columnar portion into the openings of the circuit boards when the plurality of circuit boards are stacked and fixed vertically. Further, the worker can separate the plurality of circuit boards individually simply by pulling the plurality of circuit boards from the columnar portion. In other words, the worker does not have to repeat the work for coupling or separating the plurality of spacer members dissimilarly to a conventional case where a plurality of circuit boards are stacked and fixed by extending spacer members while sequentially coupling the spacer members mounted on a single circuit board or a conventional case where a plurality of circuit boards are individually separated while sequentially separating the plurality of coupled spacer members, for example. Thus, workability in stacking and fixing the circuit boards can be improved.

The support member of a circuit board according to the aforementioned aspect comprises the columnar portion capable of reducing the outer shape by elastic deformation and capable of passing through the opening provided on the circuit board, and the plurality of projecting portions passing through the opening of the circuit board when the columnar portion is elastically deformed to reduce the outer shape, whereby the columnar portion and the plurality of projecting portions provided on the columnar portion pass through the opening of the circuit board along a thickness direction of the circuit board (in a direction where the circuit board is stacked). In other words, the columnar portion (projecting portions) can hold the circuit board also on a region other than the vicinity of the edges in an in-plane direction of the circuit board, and hence the columnar portion (projecting portions) can hold the circuit boards also on the regions other than the vicinity of the edges of the circuit boards (central region in the in-plane direction) in addition to holding the circuit board in the vicinity of the edges of the circuit boards when the circuit boards with large plane area are stacked and fixed, for example. Thus, the circuit boards can be reliably held by the spacer members.

The support member of a circuit board according to the aforementioned aspect preferably further comprises a slit portion for facilitating elastic deformation of the columnar portion, provided on the outer circumferential surface of the columnar portion along the axial direction. According to this structure, the columnar portion can be easily elastically deformed on a region provided with the slit portion

In the aforementioned structure comprising the slit portion, the slit portion is preferably formed to pass through a prescribed region of the outer circumferential surface of the columnar portion along the axial direction, and the columnar portion is preferably deformed in a direction where a width of the slit portion corresponding to regions formed with the projecting portions is reduced, so that the projecting portions pass through the opening of the circuit board. According to this structure, the outer diameter of the columnar portion can be axially reduced on regions formed with the projecting portions on the outer circumferential surface when inserting the columnar portion into the opening of the circuit board, and hence the projecting portions can be easily passed through the opening of the circuit board.

In the support member of a circuit board according to the aforementioned aspect, each of the projecting portions is preferably so formed that an outer surface protruding from the columnar portion has a substantially circular shape in plan view, and the columnar portion is preferably enabled to pass through the opening provided on the circuit board by reducing outer diameters of the substantially circular outer surfaces of the projecting portions when the columnar portion is elastically deformed to reduce the outer shape. According to this structure, the worker can easily penetrate a portion of the projecting portion through the opening of the circuit board in a state where the outer diameter of the substantially circular outer surface of the projecting portions is reduced and deformed without considering the positional relation between the columnar portion and the opening of the circuit board around the shaft of the columnar portion, dissimilarly to a case where the outer surface of each projecting portion is formed to have a shape such as a rectangular shape or a triangular shape other than the circular shape.

In the aforementioned structure comprising the slit portion, the slit portion is preferably formed to extend in a direction coincident with an axis line without inclining along the axial direction and to penetrate the outer circumferential surface. According to this structure, the worker can easily fit the plurality of circuit boards on the columnar portion by deforming the first side region along the axis line of the outer circumferential surface of the columnar portion along an extensional direction of the slit portion also when the plurality of circuit boards are sequentially fitted on the columnar portion.

In the aforementioned structure comprising the slit portion, the outer circumferential surface of the columnar portion is preferably pressed on an inner circumferential surface of the opening of the circuit board with restoring force for returning the outer shape reduced in inserting the columnar portion into the opening of the circuit board to an original size by elastic deformation, so that the columnar portion holds the circuit board on a portion between the projecting portions of the columnar portion. According to this structure, the outer circumferential surface of the columnar portion is in a state of always pressing the inner circumferential surface of the opening of the circuit board when the columnar portion holds the circuit board, and hence the circuit board can be reliably held on the portion between the projecting portions of the columnar portion.

In the aforementioned structure in which the outer surface of each of the projecting portions has a substantially circular shape, the projecting portions are preferably circumferentially formed along the outer circumferential surface of the columnar portion. According to this structure, the projecting portions are circumferentially opposed to surfaces (upper and lower surfaces) in the vicinity of the openings of the circuit boards when the columnar portion holds the circuit board, and hence the circuit board can be reliably held on the portion between the projecting portions of the columnar portion.

In the aforementioned structure in which the projecting portions are circumferentially formed, each of the projecting portions preferably has such an outer shape that a distance from a central line in the axial direction of the columnar portion to the outer surface of the projecting portion is increased along the axial direction of the columnar portion, and the columnar portion is preferably formed to be inserted into the opening of the circuit board in a state where the outer diameters of the projecting portions are elastically deformably reduced by fitting the circuit board on the columnar portion along a direction where the distance from the central line in the axial direction of the columnar portion to the outer surface of each of the projecting portions is increased when the columnar portion is inserted into the opening of the circuit board. According to this structure, the outer diameter of each of the projecting portions can be gradually reduced along the outer shape of each of the projecting portions when each of the projecting portions having the outer shape larger than the opening of the circuit board is fitted into the opening of the circuit board, and hence the columnar portion can be easily fitted into the opening of the circuit board.

In the aforementioned structure comprising the slit portion, the columnar portion is preferably formed in a hollow cylindrical shape, and the aforementioned structure comprising the slit portion preferably further comprises a pin member suppressing deformation in a direction where an outer diameter of the columnar portion is reduced in a state where the columnar portion is inserted into the opening of the circuit board by inserting the pin member along an inner circumferential surface of a hollow portion of the columnar portion. According to this structure, the outer diameter of the columnar portion is inhibited from deformation in the reduced direction in a state where the pin member is inserted into the inner circumferential surface of the columnar portion, and hence the state where the circuit board is held between the projecting portions of the columnar portion can be maintained also when an unexpected impact and so on is applied to the columnar portion.

In the aforementioned structure comprising the pin member, the columnar portion preferably includes a first engaging portion formed on the inner circumferential surface of the hollow portion of the columnar portion, the pin member preferably includes a second engaging portion formed on an outer circumferential surface of a shaft portion extending in a longitudinal direction and engaging with the first engaging portion, and the second engaging portion of the pin member is preferably engaged with the first engaging portion of the columnar portion when the pin member is inserted along the inner circumferential surface of the columnar portion, so that the pin member is inhibited from falling off the columnar portion. According to this structure, the pin member is fixed without easily falling off the columnar portion in a state where the pin member is inserted along the inner circumferential surface of the columnar portion, and hence the state where the circuit board is held between the projecting portions of the columnar portion can be maintained also when the unexpected impact is applied to the columnar portion.

In the aforementioned structure in which the columnar portion includes the first engaging portion, the first engaging portion is preferably formed on a portion of the inner circumferential surface corresponding to an end region along the axial direction of the columnar portion. According to this structure, the first engaging portion is provided on the end region of the columnar portion which is an entrance for inserting or taking out the pin member dissimilarly to a case where the first engaging portion is formed on an inner region (central region) along the axial direction of the columnar portion, and hence the worker can easily fix or take out the pin member.

In the aforementioned structure in which the columnar portion includes the first engaging portion, the first engaging portion is preferably formed by a recess portion where the inner circumferential surface of the columnar portion is concaved while the second engaging portion is preferably formed by a protruding portion where the shaft portion of the pin member protrudes toward the recess portion, and the first engaging portion is preferably formed on a portion of the inner circumferential surface at a position corresponding to a projecting portion arranged on an end region along the axial direction of the columnar portion among the plurality of projecting portions. According to this structure, the first engaging portion formed by the recess portion is formed on the inner circumferential surface at the position corresponding to the projecting portion with an increased thickness as compared with a case of forming the first engaging portion on the thinner inner circumferential surface, provided with no projecting portions, of the columnar portion, and hence an engagement state of the second engaging portion formed by the protruding portion and the first engaging portion can be reliably maintained.

In the aforementioned structure comprising the pin member, the pin member is preferably so formed that a shaft portion is tapered toward a forward end side in a longitudinal direction. According to this structure, the shaft portion is tapered toward the forward end side and hence the pin member can be easily inserted along the inner circumferential surface of the columnar portion, and a contact state of the pin member with the inner circumferential surface of the columnar portion can be immediately canceled with an operation for pulling out the pin member also when the pin member is pulled out of the columnar portion.

In the aforementioned structure in which the shaft portion of the pin member is tapered, the columnar portion is preferably so formed that an inner diameter of the hollow portion is reduced along the axial direction of the columnar portion to correspond to the tapered shape of the pin member. According to this structure, a space between the outer circumferential surface of the shaft portion of the pin member and the inner circumferential surface of the columnar portion can be kept at a constant distance along the axial direction of the columnar portion when the pin member is inserted into the hollow portion of the columnar portion, and hence the pin member can be easily inhibited from backlash inside the columnar portion.

In the support member of a circuit board according to the aforementioned aspect, a step portion is preferably formed between the outer circumferential surface of a portion between the projecting portions, holding the circuit board, of the columnar portion and an outer surface of each of the projecting portions, and a surface of the circuit board is preferably in contact with the step portion in a state where the columnar portion is inserted into the opening of the circuit board, so that the circuit board is inhibited from falling off the columnar portion. According to this structure, the pin member is fixed without easily falling off the columnar portion in a state where the pin member is inserted along the inner circumferential surface of the columnar portion, and hence the state where the circuit boards is held between the projecting portions of the columnar portion can be maintained also when the unexpected impact is applied to the columnar portion.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is an exploded perspective view showing the structure of a spacer member according to an embodiment of the present invention;
Fig. 2 is a perspective view showing a state of stacking and holding a plurality of circuit boards by the spacer member according to the embodiment shown in Fig. 1;
Fig. 3 is a sectional view showing a state of stacking and holding the plurality of circuit boards by the spacer member according to the embodiment shown in Fig. 1;
Fig. 4 is a perspective view showing the structure of the circuit board held by the spacer member according to the embodiment shown in Fig. 1;
Figs. 5 to 7 are sectional views showing a halfway state where the spacer member is inserted into an opening of the circuit board according to the embodiment shown in Fig. 1;
Figs. 8 and 9 are sectional views showing a state where the spacer member holds the circuit board according to the embodiment shown in Fig. 1;
Fig. 10 is a sectional view showing a state where the spacer member holds the plurality of circuit boards according to the embodiment shown in Fig. 1;
Fig. 11 is a sectional view showing a halfway state of taking out the circuit board from the spacer member according to the embodiment shown in Fig. 1;
Fig. 12 is a perspective view showing a circuit board with large plane area according to a modification of the present invention; and
Fig. 13 is a perspective view showing a state of holding the circuit board with large plane area by the spacer member shown in Fig. 11.

### DESCRIPTION OF THE PREFERRED EMBODIMENTS

An embodiment of the present invention will be hereinafter described with reference to the drawings.

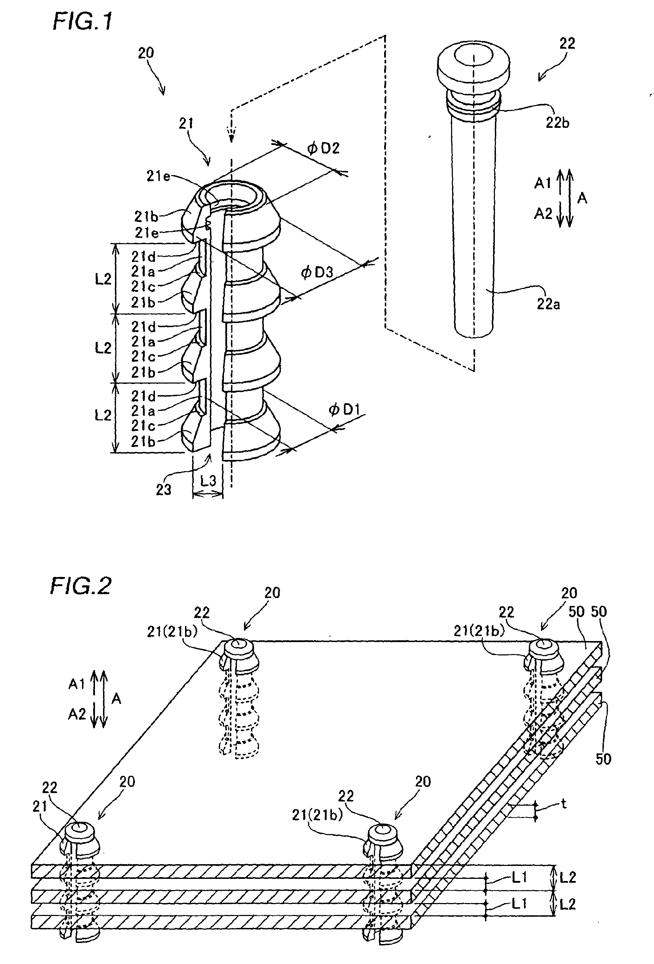

A support structure of spacer members 20 according to an embodiment of the present invention and circuit boards 50 employing these spacer members 20 will be described with reference to Figs. 1 to 11. Each spacer member 20 is an example of the "support member" in the present invention.

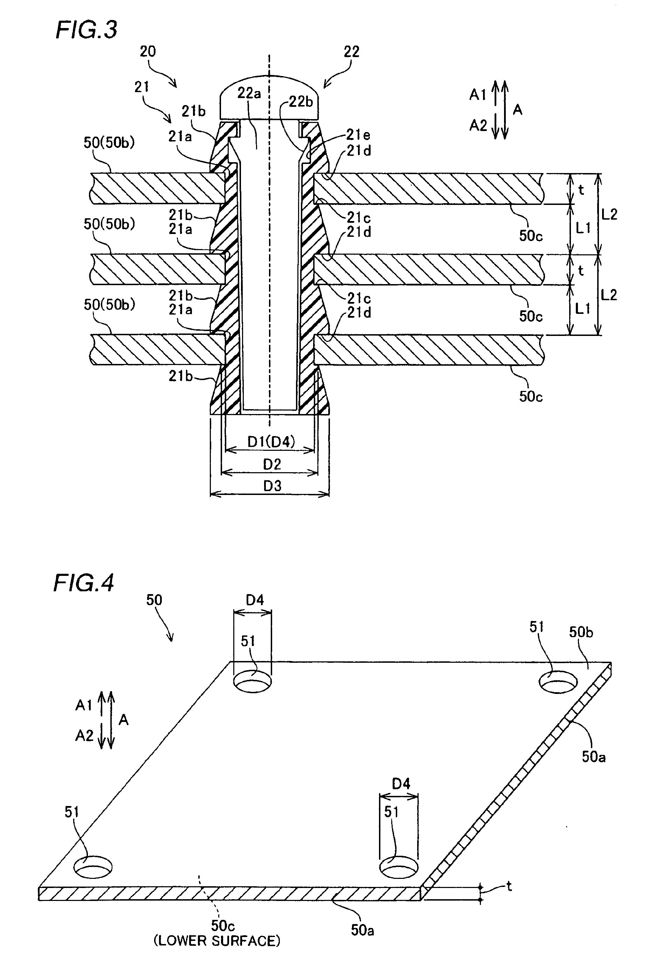

Each spacer member 20 according to the embodiment of the present invention comprises a shaft body 21 made of resin such as polypropylene, having a hollow shape, and a pin member 22 made of metal, coaxially inserted into the shaft body 21 in a direction A, as shown in Fig. 1. In the support structure of the circuit boards 50 employing theses spacer members 20, a plurality (three in this embodiment) of the circuit boards 50 are formed to be held in a state of being stacked at intervals L1 vertically (in the direction A) with the four spacer members 20 (see Fig. 2), as shown in Figs. 2 and 3.

According to this embodiment, the shaft body 21 constituting each spacer member 20 is constituted by a columnar portion 21a having an outer diameter D1 and extending axially (in the direction A) and a plurality (four in this embodiment) of projecting portions 21b axially arranged in a period of intervals L2 and protruding radially from an outer circumferential surface of the columnar portion 21a, as shown in Fig. 1. In the shaft body 21, the columnar portion 21a and the plurality of projecting portions 21b are integrally formed by resin molding.

Each projecting portion 21b of the shaft body 21 is formed circumferentially along an outer circumferential surface of the columnar portion 21a, and an outer surface is formed in a shape where an outer diameter is increased at a constant rate from an axial first side (side along arrow A1) to an axial second side (side along arrow A2) (in the range of outer diameters D2 to D3 (D2<D3) shown in Fig. 1). The projecting portion 21b has flanged step portions 21c and 21d radially protruding on boundary portions between the axial columnar portion 21a and the projecting portion 21b along the axial direction. A distance between a pair of the step portions 21c and 21d opposed axially (in the direction A) with the columnar portion 21a therebetween has a size substantially equal to a thickness t of each circuit board 50 shown in Fig. 2.

According to this embodiment, the shaft body 21 is provided with a slit portion 23 linearly penetrating the columnar portion 21a and the projecting portions 21b from a first end (side along arrow A1) toward a second end (side along arrow A2), as shown in Fig. 1.

In other words, the shaft body 21 has a substantially C-shaped radial cross section, and hence the outer shapes of the columnar portion 21a and the projecting portions 21b are enabled to be elastically deformably reduced (narrowed) by taking the columnar portion 21a between fingers of a worker to narrow a width L3 (see Fig. 1) of the slit portion 23, for example. The shaft body 21 of the spacer members 20 is made of a resin material, so that the temporarily reduced outer shape is returned to an original shape in a state where no external force is applied to the shaft body 21. Fig. 1 shows a natural shape of the shaft body 21 in a state where no external force is applied to the columnar portion 21a and so on.

As shown in Fig. 4, each circuit board 50 supported by the shaft bodies 21 of the spacer members 20 is formed with substantially circular openings 51 having an inner diameter D4 on portions located inward from edges 50a of the circuit board by a prescribed distance. The outer diameter D1 of the columnar portions 21a is slightly larger than the inner diameter D4 of the openings 51 (see Fig. 4) of the circuit board 50 when the shaft bodies 21 (see Fig. 1) are in the natural state.

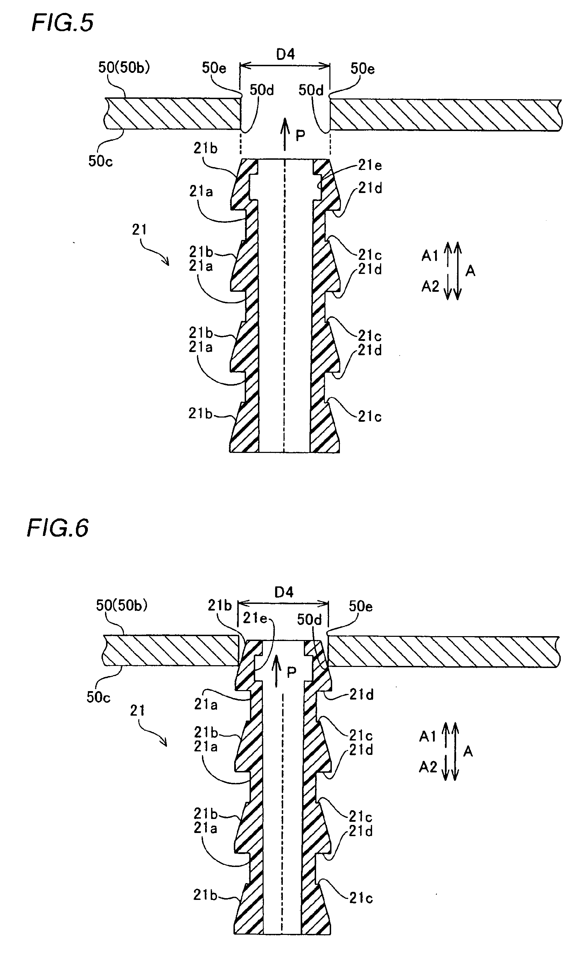

According to this embodiment, as shown in Figs. 5 to 8 in this order, each shaft body 21 is enabled to pass through the opening 51 of the circuit board 50 along arrow P from the side along arrow A2 (circuit board lower surface 50c side) to the side along arrow A1 (circuit board upper surface 50b side) by temporarily reducing the outer diameter D1 (see Fig. 1) of the elastically deformable columnar portion 21a and the outer diameter (in the range of D2 to D3: see Fig. 1) of the elastically deformable projecting portions 21b as compared with the inner diameter D4 of the opening 51. When the shaft body 21 is inserted into the opening 51, the shaft body 21 is inserted into the opening 51 of the circuit board 50 from the first end (end on the side along arrow A1) first, as shown in Fig. 5. Thus, the shaft body 21 is formed to pass through the opening 51 from the first end (side along arrow A1) toward the second end (side along arrow A2) while sequentially reducing and deforming the outer diameter D1 of the columnar portion 21a and the outer diameters D2 and D3 of the projecting portions 21b from the side along arrow A1 toward the side along arrow A2 (see Figs. 5 to 7).

Each projecting portion 21b has a shape where the outer diameter of the outer surface is increased at the constant rate from the axial first side (side along arrow A1) to the axial second side (side along arrow A2). In other words, the sectional shape of the projecting portion 21b is formed to protrude from the columnar portion 21a in a state where the outer surface has a substantially constant inclined angle with respect to an axis line (alternate long and short dash lines) of the shaft body 21, as shown in Fig. 3. Therefore, an edge portion 50d on the side along arrow A2 (circuit board lower surface 50c side) of the opening 51 is formed to slide along arrow A2 while sliding on the outer surface of the projecting portion 21b when the projecting portion 21b passes through the opening 51, as shown in Fig. 6.

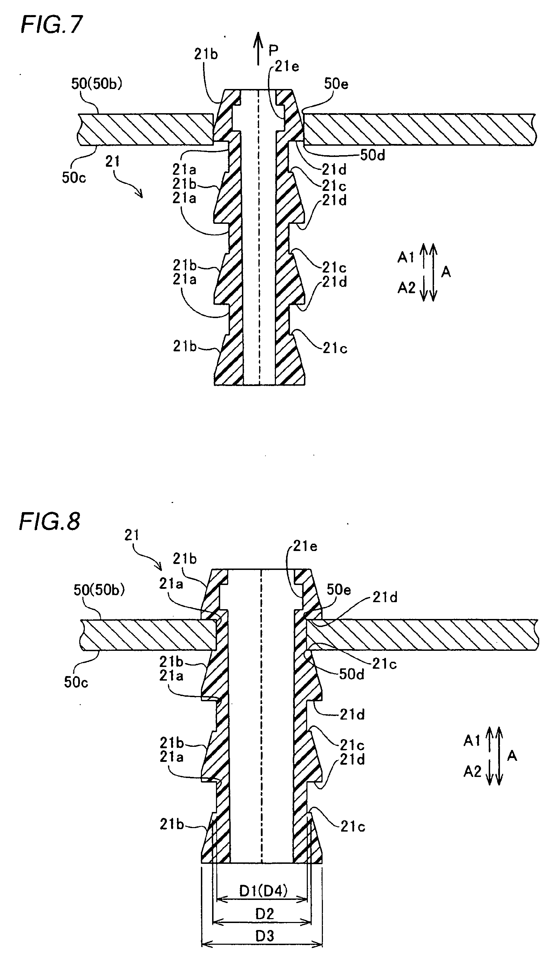

According to this embodiment, in the shaft body 21 inserted into the opening 51, the outer diameter of the projecting portion 21b on the side along arrow A1 attempts to return to an original size by restoring force of elastically deformed portions (the columnar portion 21a or the projecting portions 21b) directly after this projecting portion 21b has passes through the opening 51, and hence the circuit board 50 is formed to be held by the portion of the columnar portion 21a between the projecting portion 21b which has already passed through and the projecting portion 21b which will pass through next, as shown in Fig. 8. At this time, the outer diameter of the columnar portion 21a of the portion to hold the circuit board 50 is also returned to an original size (D1), and hence the circuit board 50 is held on the portion between the projecting portions 21b of the columnar portion 21a in a state where the outer circumferential surface of the columnar portion 21a presses an inner circumferential surface of the opening 51 of the circuit board 50.

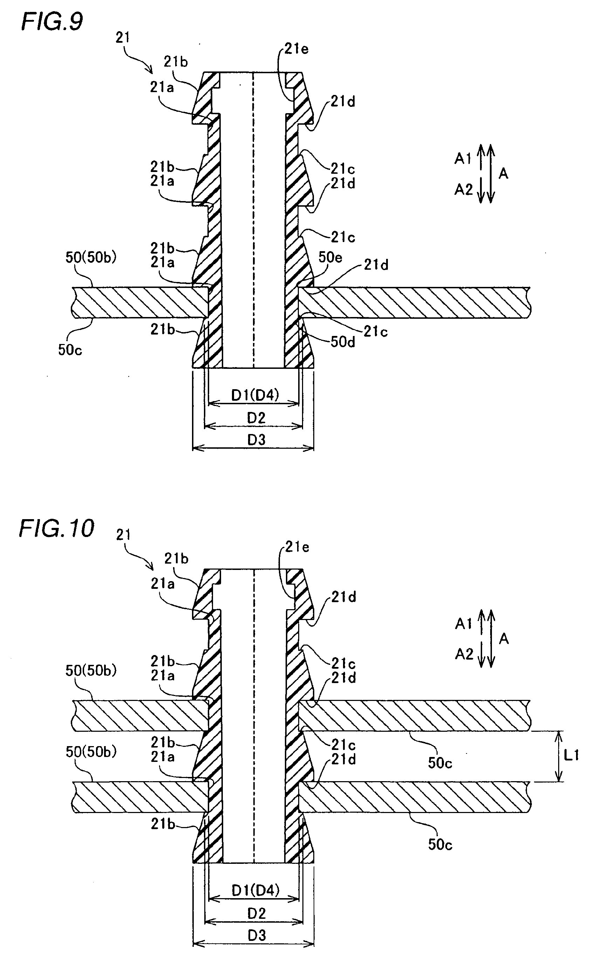

The circuit board 50 continuously passes the projecting portions 21b (two portions) axially provided on the side along arrow A2 as shown in Fig. 9 when the outer diameters (D1, D2 and D3) of the shaft body 21 are reduced again from a state shown in Fig. 8, and hence this circuit board 50 is formed to be held on a portion between a portion of the lowermost columnar portion 21a on the side along arrow A2.

As shown in Figs. 8 or 9, when the circuit board 50 is held between the projecting portions 21b of the columnar portion 21a, the circuit board 50 is formed to be held in a state where the edge portion 50d on the side along arrow A2 of the openings 51 is in contact with the step portion 21c and an edge portion 50e on the side along arrow A1 of the opening 51 is in contact with the step portion 21d. Thus, in the state where no external force reducing the outer diameter (outer diameter shape) is applied to the shaft body 21, the circuit board 50 is so formed that the state where the circuit board 50 is held between the projecting portions 21b of the columnar portion 21a is maintained.

According to this embodiment, another circuit board 50 is inserted from the first end (on the side along arrow A1) of the shaft body 21 in a state shown in Fig. 9, so that this another circuit board 50 is held on a portion of the second columnar portion 21a viewed from the side along arrow A1, as shown in Fig. 10. In other words, the two circuit boards 50 are held in a state of being stacked at the interval L1 from the first circuit board 50.

According to this embodiment, the worker repeats the work for holding the circuit board 50 between the projecting portions 21b of the columnar portion 21a by the aforementioned method, so that the plurality (three in this embodiment) of circuit boards 50 are held in the state of being stacked at the intervals L1 vertically (in the direction A) with the spacer members 20, as shown in Fig. 3.

According to this embodiment, the pin member 22 is enabled to be fitted into the hollow portion (inner circumferential surface of the columnar portion 21a) of the shaft body 21 from the side along arrow A1 toward the side along arrow A2 in a state where the shaft body 21 is inserted into the plurality of circuit boards 50 to be held, as shown in Fig. 3. A ring shaped (circumferential) groove portion 21e which is radially concaved is formed on the inner circumferential surface of the projecting portion 21b closest to the side along arrow A1 of the shaft body 21, and a protruding portion 22b protruding in the form of a rib from an outer circumferential surface of a shaft portion 22a is formed in the vicinity of a base of the shaft portion 22a of the pin member 22. Therefore, the protruding portion 22b of the pin member 22 is formed to be fitted into the groove portion 21e of the shaft body 21 when the pin member 22 is fitted into the shaft body 21, as shown in Fig. 3. Thus, the fitted pin member 22 is prevented from falling off the shaft body 21. The groove portion 21e and the protruding portion 22b are examples of the "first engaging portion" and the "second engaging portion" in the present invention, respectively. The groove portion 21e is an example of the "recess portion" in the present invention.

As shown in Figs. 1 and 3, the pin member 22 is so formed that the shaft portion 22a is tapered along a longitudinal direction (direction A) of the shaft portion 22a. The shaft body 21 is so formed that an inner diameter of the inner circumferential surface of the columnar portion 21a gradually reduces from the side along arrow A1 to the side along arrow A2 to substantially correspond to the tapered shape of the shaft portion 22a of the pin member 22. In other words, an inner diameter of the hollow portion of the columnar portion 21a of a portion corresponding to a forward end (on the side along arrow A2) of the shaft portion 22a of the pin member 22 is rendered slightly smaller than an inner diameter of the hollow portion of the columnar portion 21a of a portion corresponding to the base (on the side along arrow A1) of the shaft portion 22a of the pin member 22 in Fig. 3. Thus, the pin member 22 has the shaft portion 22a tapered along arrow A2, and hence the pin member 22 can be easily inserted along the inner circumferential surface of the columnar portion 21a.

The shaft body 21 may be so formed that the shape (gradient of the axial taper) of the inner circumferential surface of the columnar portion 21a completely corresponds to the tapered shape of the pin member 22 (shaft portion 22a), or the inner circumferential surface of the columnar portion 21a may be formed to have a shelving (about 1°, for example) as compared with the tapered shape (about 1.5°) of the pin member 22. Thus, the inserted pin member 22 can be more easily pulled out also when the pin member 22 is pulled out of the columnar portion 21a.

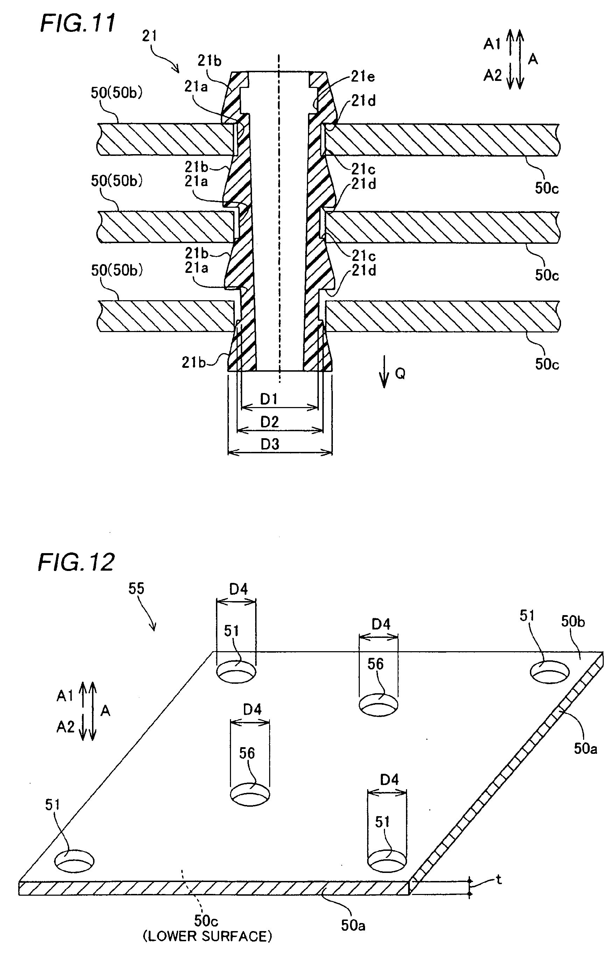

When the circuit boards 50 held by the spacer members 20 are dismounted from each spacer member 20, the circuit board 50 held on a position closest to the side along arrow A2 (on a lower side) is first dismounted from the shaft body 21 in a state of pulling out the pin member 22 (see Fig. 3), as shown in Fig. 11. In other words, each of the outer diameter D1 of the shaft body 21 (columnar portion 21a) and the outer diameter (in the range of D2 to D3) of the projecting portions 21b is temporarily rendered smaller than the inner diameter D4 of the opening 51, so that the lowermost circuit board 50 can pass through along arrow Q from the side along arrow A1 to the side along arrow A2, similarly to the aforementioned case where the shaft body 21 (see Figs. 5 to 8) is inserted into the circuit board 50. The remaining two circuit boards 50 other than the lowermost circuit board 50 are also sequentially dismounted from the spacer member 20 by passing through the shaft body 21 from the side along arrow A1 to the side along arrow A2, thereby dismounting all of the circuit boards 50.

According to this embodiment, as hereinabove described, the spacer member 20 comprises the shaft body 21 (columnar portion 21a) capable of passing through the opening 51 provided on the circuit board 50, and the plurality of projecting portions 21b arranged at the intervals L1 in the axial direction (direction A) of the shaft body 21 (columnar portion 21a) and passing through the opening 51 of the circuit board 50. The circuit boards 50 are arranged between the projecting portions 21b in the axial direction of the columnar portion 21a in the state where the shaft body 21 passes through the openings 51 of the circuit boards 50, so that the plurality of circuit boards 50 are held at the intervals L1 along the axial direction (direction A) of the shaft body 21 (columnar portion 21a), whereby the worker can stack and fix the individual circuit boards 50 vertically simply by inserting the shaft body 21 (columnar portion 21a) into the openings 51 of the circuit boards 50 when the plurality of circuit boards 50 are stacked and fixed vertically (in the direction A). The worker can separate the plurality of circuit boards 50 individually simply by pulling the plurality of circuit boards 50 from the shaft body 21 (columnar portion 21a). In other words, the worker does not have to repeat the work for coupling or separating the plurality of spacer members dissimilarly to a case where a plurality of circuit boards 50 are stacked and fixed by extending spacer members while sequentially coupling the spacer members mounted on a single circuit board or a case where a plurality of circuit boards 50 are individually separated while sequentially separating the plurality of coupled spacer members, for example. Thus, workability in stacking and fixing the circuit boards 50 can be improved.

According to this embodiment, the spacer member 20 comprises the shaft body 21 (columnar portion 21a) capable of reducing the outer diameter by elastic deformation and capable of passing through the opening 51 provided on the circuit board 50 and the plurality of projecting portions 21b passing through the opening 51 of the circuit board 50 when the outer diameter is reduced by elastic deformation of the columnar portion 21a of the shaft body 21, whereby the columnar portion 21a and the plurality of projecting portions 21b provided on the columnar portion 21a pass through the opening 51 of the circuit board along a thickness direction of the circuit board 50 (in the direction A where the circuit board is stacked). In other words, the columnar portion 21a (projecting portions 21b) can hold the circuit board 50 also on a region other than the vicinity of the edges 50a in an in-plane direction of the circuit board 50, and hence the columnar portion 21a (projecting portions 21b) can hold the circuit boards 50 also on the regions other than the vicinity of the edges 50a of the circuit boards 50 (central region in the in-plane direction of the circuit board) in addition to holding the circuit board in the vicinity of the edges of the circuit boards 50 when the circuit boards 50 with large plane area are stacked and fixed, for example. Thus, the circuit boards 50 can be reliably held by the spacer members 20.

According to this embodiment, the spacer member 20 comprises the slit portion 23 for facilitating elastic deformation of the columnar portion 21a, provided on the outer circumferential surface of the columnar portion 21a along the axial direction (direction A), whereby the shaft body 21 (columnar portion 21a) can be easily elastically deformed on a region provided with the slit portion 23.

According to this embodiment, the slit portion 23 is formed to pass through the prescribed region of the outer circumferential surface of the shaft body 21 (columnar portion 21a) along the axial direction (direction A), and the projecting portions 21b pass through the opening 51 of the circuit board 50 by deforming the columnar portion 21a in the direction where the width of the slit portion 23 corresponding to regions formed with the projecting portions 21b is reduced, whereby the outer diameter D1 of the columnar portion 21a can be axially reduced on the regions formed with the projecting portions 21b on the outer circumferential surface when inserting the shaft body 21 (columnar portion 21a) into the opening 51 of the circuit board 50, and hence the projecting portions 21b can be easily passed through the opening 51 of the circuit board 50.

According to this embodiment, the outer circumferential surface of the columnar portion 21a is pressed on the inner circumferential surface of the opening 51 of the circuit board 50 with restoring force for returning the outer diameter (outer shape) reduced in inserting the columnar portion 21a into the opening 51 of the circuit board 50 to the original size by elastic deformation, so that the columnar portion 21a holds the circuit board 50 on the portion between the projecting portions 21b of the columnar portion 21a, whereby the outer circumferential surface of the columnar portion 21a is in a state of always pressing the inner circumferential surface of the opening 51 of the circuit board 50 when the columnar portion 21a holds the circuit boards 50, and hence the circuit board 50 can be reliably held on the portion between the projecting portions 21b of the columnar portion 21a.

According to this embodiment, each projecting portion 21b is so formed that the outer surface protruding from the columnar portion 21a has a substantially C-shape formed by a substantially circular curved surface in plan view, whereby the worker can easily penetrate the portion of the projecting portion 21b through the opening 51 of the circuit board 50 in a state where the outer diameter D2 (D3) of the substantially circular outer surface of the projecting portions 21b is reduced and deformed without considering the positional relation between the columnar portion 21a and the opening 51 of the circuit board 50 around the shaft of the columnar portion 21a, dissimilarly to a case where the outer surface of each projecting portion 21b is formed to have a shape such as a rectangular shape or a triangular shape other than the circular shape, for example.

According to this embodiment, the slit portion 23 is formed to extend in a direction (direction A) coincident with the axis line without inclining along the axial direction of the shaft body 21 and to penetrate the outer circumferential surface of the columnar portion 21a, whereby the worker can easily fit the plurality of circuit boards 50 on the columnar portion 21a by deforming the first side region along the axis line of the outer circumferential surface of the columnar portion 21a along an extensional direction of the slit portion 23 also when the plurality of circuit boards 50 are sequentially fitted on the columnar portion 21a.

According to this embodiment, the projecting portions 21b are circumferentially formed along the outer circumferential surface of the columnar portion 21a, whereby the projecting portions 21b are circumferentially opposed to the surfaces (the upper and lower surfaces 50b and 50c of the circuit board) in the vicinity of the openings 51 of the circuit boards 50 when the columnar portion 21a holds the circuit board 50, and hence the circuit board 50 can be reliably held on the portion between the projecting portions 21b of the shaft body 21 (columnar portion 21a).

According to this embodiment, each projecting portion 21b is formed to have such an outer shape that a distance from a central line in the axial direction (direction A) of the columnar portion 21a to the outer surface of the projecting portion 21b is increased along the axial direction of the columnar portion 21a, and the columnar portion 21a is formed to be inserted into the opening 51 of the circuit board 50 in a state where the outer diameters D2 and D3 of the projecting portion 21b are elastically deformably reduced by fitting the circuit board 50 on the columnar portion 21a along a direction where the distance from the central line in the axial direction of the columnar portion 21a to the outer surface of the projecting portion 21b is increased when the columnar portion 21a is inserted into the opening 51 of the circuit board 50, whereby the outer diameter of the projecting portion 21b can be gradually reduced along the outer shape of the projecting portion 21b when the projecting portion 21b having the outer shape larger than the opening 51 of the circuit board 50 is fitted into the opening 51 of the circuit board 50, and hence the columnar portion 21a can be easily fitted into the opening 51 of the circuit board 50.

According to this embodiment, the spacer member 20 comprises the pin member 22 suppressing deformation in the direction where the outer diameter of the columnar portion 21a is reduced in a state where the columnar portion 21a is inserted into the opening 51 of the circuit board 50 by inserting the pin member 22 along the inner circumferential surface of the hollow portion of the columnar portion 21a, whereby the outer diameter D1 of the columnar portion 21a is inhibited from deformation in the reduced direction in a state where the pin member 22 is inserted into the inner circumferential surface of the shaft body 21 (columnar portion 21a), and hence the state where the circuit board 50 is held between the projecting portions 21b of the columnar portion 21a can be maintained also when an unexpected impact and so on is applied to the shaft body 21 (columnar portion 21a).

According to this embodiment, the protruding portion 22b of the pin member 22 is engaged with the groove portion 21e of the columnar portion 21a when the pin member 22 is inserted into the inner circumferential surface of the shaft body 21 (columnar portion 21a), so that the pin member 22 is inhibited from falling off the columnar portion 21a, whereby the pin member 22 is fixed without easily falling off the columnar portion 21a in a state where the pin member 22 is inserted along the inner circumferential surface of the shaft body 21 (columnar portion 21a), and hence the state where the circuit board 50 is held between the projecting portions 21b of the columnar portion 21a can be maintained also when the unexpected impact is applied to the shaft body 21 (columnar portion 21a).

According to this embodiment, the groove portion 21e is formed on the portion of the inner circumferential surface corresponding to an end region (on the side along arrow A1) along the axial direction of the columnar portion 21a, whereby the groove portion 21e is provided on the end region of the columnar portion 21a which is an entrance for inserting or taking out the pin member 22 dissimilarly to a case where the groove portion 21e is formed on an inner region (central region) along the axial direction (direction A) of the columnar portion 21a, and hence the worker can easily fix or take out the pin member 22.

According to this embodiment, the groove portion 21e is a recess portion where the inner circumferential surface of the columnar portion 21a is concaved, and the protruding portion 22b protruding toward the groove portion 21e is formed on the pin member 22, and the groove portion 21e is formed on the inner circumferential surface at a position corresponding to the projecting portion 21b arranged on the end region along the axial direction of the columnar portion 21a in the plurality (four) of the projecting portions 21b, whereby the groove portion 21e is formed on the inner circumferential surface at the position corresponding to the projecting portion 21b with an increased thickness as compared with a case of forming the groove portion 21e on the thinner inner circumferential surface, provided with no projecting portions 21b, of the columnar portion 21a, and hence an engagement state of the protruding portion 22b and the groove portion 21e can be reliably maintained.

According to this embodiment, the pin member 22 is so formed that the shaft portion 22a is tapered toward the forward end side in the longitudinal direction (direction A), whereby the shaft portion 22a is tapered toward the forward end side and hence the pin member 22 can be easily inserted along the inner circumferential surface of the shaft body 21 (columnar portion 21a), and a contact state of the pin member 22 with the inner circumferential surface of the columnar portion 21a can be immediately canceled with an operation for pulling out the pin member 22 also when the pin member 22 is pulled out of the shaft body 21 (columnar portion 21a).

According to this embodiment, the columnar portion 21a is so formed that the inner diameter of the hollow portion is reduced along the axial direction (along arrow A2) of the columnar portion 21a to correspond to the tapered shape of the pin member 22, whereby a space between the outer circumferential surface of the shaft portion of the pin member 22 and the inner circumferential surface of the columnar portion 21a can be kept at a constant distance along the axial direction of the columnar portion 21a when the pin member 22 is inserted into the hollow portion of the columnar portion 21a, and hence the pin member 22 can be inhibited from backlash inside the columnar portion 21a.

According to this embodiment, the step portion 21c (21d) are formed between the outer circumferential surface of portions between the projecting portions 21b, holding the circuit boards 50, of the shaft body 21 (columnar portion 21a) and the outer surfaces of the projecting portions 21b, and the surfaces of the circuit boards 50 (the upper and lower surfaces 50b and 50c of the circuit boards) are in contact with the step portions 21c (21d) in a state where the columnar portion 21a is inserted into the openings 51 of the circuit boards 50, so that the circuit boards 50 are inhibited from falling off the columnar portions 21a, whereby the pin member 22 is fixed without easily falling off the columnar portion 21a in a state where the pin member 22 is inserted along the inner circumferential surface of the columnar portion 21a, and hence the state where the circuit boards 50 is held between the projecting portions 21b of the columnar portion 21a can be maintained also when the unexpected impact is applied to the shaft body 21 (columnar portion 21a).

According to this embodiment, the groove portion 21e is circumferentially formed along the inner circumferential surface of the columnar portion 21a, whereby the protruding portion 22b can be engaged with the groove portion 21e without a rotational angle around the shaft of the columnar portion 21a, and hence the worker can easily engage the groove portion 21e and the protruding portion 22b.

According to this embodiment, each of the plurality (four) of the projecting portions 21b is formed to have the outer shape where the distance from the central line in the axial direction of the columnar portion 21a to the outer surface of the projecting portion 21b is increased along a direction where the circuit board 50 is fitted on the columnar portion 21a, whereby the plurality of projecting portions 21b can be formed to align the outer shapes in the same direction (where the circuit board 50 is fitted on the columnar portion 21a (along arrow A2)), and hence the plurality of circuit boards 50 can be easily fitted on the columnar portion 21a along the same direction.

According to this embodiment, each projecting portion 21b is so formed that the distance from the central line in the axial direction of the columnar portion 21a to the outer surface is increased by protruding the outer surface from the outer circumferential surface of the columnar portion with the substantially constant inclined angle along the axial direction of the columnar portion 21a, whereby the outer diameter of the projecting portion 21b can be reduced along the outer shape of the projecting portion 21b with the constant inclined angle when the columnar portion 21a is fitted into the opening 51 of the circuit board 50, and hence the columnar portion 21a can be easily fitted into the opening 51 of the circuit board 50.

According to this embodiment, the circuit board 50 is slid on the columnar portion 21a along the direction where the circuit board 50 is fitted on the columnar portion 21a when each of the projecting portions 21b passes through the opening 51 of the circuit board 50, so that each of the projecting portions 21b passes through in an opposite direction to the direction where the projecting portion 21b is fitted into the opening 51 of the circuit board 50 in a state where the outer diameters of the projecting portion 21b are elastically deformably reduced, whereby the circuit board 50 can be taken out from the spacer member 20 by passing the projecting portions 21b through the opening 51 of the circuit board 50 along the same direction as the direction where the circuit board 50 is fitted on the columnar portion 21a also when the worker takes out the circuit board 50 from the spacer member 20, and hence the work of the worker can be simplified.

According to this embodiment, the columnar portion 21a is made of elastically deformable resin, whereby the shaft body 21 (columnar portion 21a) can be passed through the opening 51 of the circuit board 50 by easily reducing the outer diameter (outer shape) by elastic deformation of the resin material.

Although the present invention has been described and illustrated in detail, it is clearly understood that the same is by way of illustration and example only and is not to be taken by way of limitation, the spirit and scope of the present invention being limited only by the terms of the appended claims.

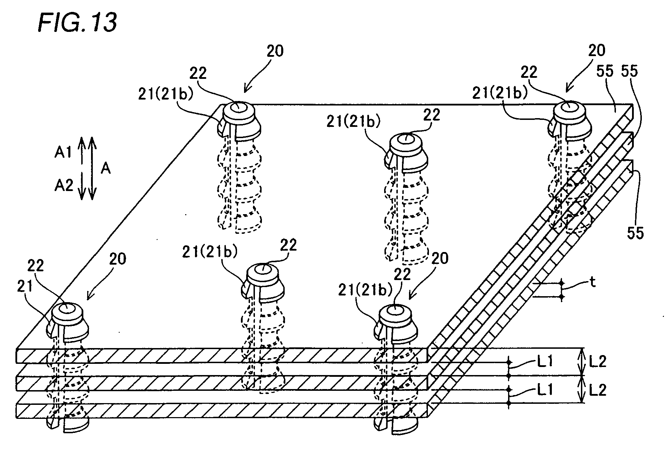

For example, while the plurality of circuit boards 50 provided with openings 51 in the vicinity of the edges 50a are held by the spacer members 20 in the aforementioned embodiment, the present invention is not restricted to this but the spacer members 20 can be employed also when a plurality of circuit boards 55 with a larger plane area than the circuit boards 50 are stacked and fixed as in a modification shown in Figs. 12 and 13. In other words, the spacer members 20 can be inserted into openings 56 from a direction perpendicular to surfaces of the circuit boards 55 also when the openings 56 are provided on regions (central region in the in-plane direction in Fig. 11) other than the vicinity of the edges of the circuit boards 55 in addition to the openings 51, and hence the circuit boards 55 are held also on positions provided with the openings 56 in a state where the intervals L1 are maintained by the spacer members 20. Thus, the plurality of circuit boards 55 can be reliably held by the spacer members 20 also when the circuit boards 55 with the large plane area are stacked and held.

While the spacer members 20 hold the three circuit boards 50 in the aforementioned embodiment, the present invention is not restricted to this but four or more circuit boards 50 may be held by increasing an axial length of the spacer members 20 and increasing the number of the projecting portions 21b.

While the protruding portion 22b is provided on the shaft portion 22a of the pin member 22, and the groove portion 21e is provided on the inner circumferential surface of the shaft body 21, so that the pin member 22 and the shaft body 21 are engaged in the state where the pin member 22 is inserted into the shaft body 21 in the aforementioned embodiment, the present invention is not restricted to this but a groove portion (recess portion) may be provided on the shaft portion 22a of the pin member 22 while a protruding portion (projecting portion) may be provided on the inner circumferential surface of the shaft body 21, so that both are engaged with each other.

While the shaft portion 22a of the pin member 22 is tapered and the shaft body 21 is formed by the inner circumferential surface with the inner diameter corresponding to the tapered shape of the pin member 22 in the aforementioned embodiment, the present invention is not restricted to this but the shaft portion of the pin member 22 and the inner circumferential surface of the shaft body 21 may be formed to have uniform diameters (outer and inner diameters) which are not changed along the axial direction.

While the shaft body 21 (the columnar portion 21a and the projecting portions 21b) is made of polypropylene resin in the aforementioned embodiment, the present invention is not restricted to this but the shaft body 21 may be made of a material such as polyethylene resin or a rubber material other than polypropylene resin so far as the shaft body 21 can be elastically deformably formed.

While the pin member 22 made of metal is employed in the aforementioned embodiment, the present invention is not restricted to this but a pin member made of a material other than metal, made by resin molding, for example, may be employed.

## Claims

1. A support member (20) of a circuit board (50) comprising:
a columnar portion (21a) capable of reducing an outer shape by elastic deformation and capable of passing through an opening (51) provided on the circuit board (50); and
a plurality of projecting portions (21 b) provided to protrude from an outer circumferential surface of said columnar portion (21a), arranged at a prescribed interval (L2) in an axial direction of said columnar portion (21 a), and passing through said opening (51) of said circuit board (50) when said columnar portion (21a) is elastically deformed to reduce said outer shape, and
said circuit board (50) is arranged between said projecting portions (21 b) adjacent in the axial direction of said columnar portion (21a) in a state where said columnar portion (21 a) passes through said opening (51) of said circuit board (50), so that a plurality of said circuit boards (50) are held at said prescribed interval (L2) along the axial direction of said columnar portion (21a),
**characterized in that**
each of said projection portions (21 b) is circumferentially formed along an outer circumferential surface of said columnar portion (21a), has a flanged step portion (21c, 21d) for holding said circuit board (50) and has an outer surface inclined in the same direction with respect to the axial direction of said columnar portion (21a).

2. The support member (20) of a circuit board (50) according to claim 1, further comprising a slit portion (23) for facilitating elastic deformation of said columnar portion (21a), provided on said outer circumferential surface of said columnar portion (21 a) along said axial direction.

3. The support member (20) of a circuit board (50) according to claim 2, wherein
said slit portion (23) is formed to penetrate a prescribed region of said outer circumferential surface of said columnar portion (21 a) along said axial direction, and said columnar portion (21a) is deformed in a direction where a width (L3) of said slit portion (23) corresponding to regions formed with said projecting portions (21 b) is reduced, so that said projecting portions (21b) pass through said opening (51) of said circuit board (50).

4. The support member (20) of a circuit board (50) according to claim 1, wherein
each of said projecting portions (21b) is so formed that an outer surface protruding from said columnar portion (21a) has a circular shape in plan view, and
said columnar portion (21a) is enabled to pass through said opening (51) provided on said circuit board (50) by reducing outer diameters of said circular outer surfaces of said projecting portions (21b) when said columnar portion (21a) is elastically deformed to reduce said outer shape.

5. The support member (20) of a circuit board (50) according to claim 2, wherein said slit portion (23) is formed to extend in a direction coincident with an axis line without inclining along said axial direction and to penetrate said outer circumferential surface.

6. The support member (20) of a circuit board (50) according to claim 2, wherein
said outer circumferential surface of said columnar portion (21a) is pressed on an inner circumferential surface of said opening (51) of said circuit board (50) with restoring force for returning said outer shape reduced in inserting said columnar portion (21a) into said opening (51) of said circuit board (50) to an original size by elastic deformation, so that said columnar portion (21a) holds said circuit board (50) on a portion between said projecting portions (21b) of said columnar portion (21a).

7. The support member (20) of a circuit board (50) according to claim 4, wherein said projecting portions (21b) are circumferentially formed along said outer circumferential surface of said columnar portion (21a).

8. The support member (20) of a circuit board (50) according to claim 7, wherein
each of said projecting portions (21b) has such an outer shape that a distance from a central line in the axial direction of said columnar portion (21a) to said outer surface of said projecting portion is increased along the axial direction of said columnar portion (21a), and
said columnar portion (21a) is formed to be inserted into said opening (51) of said circuit board (50) in a state where said outer diameters of said projecting portions (21 b) are elastically deformably reduced by fitting said circuit board (50) on said columnar portion (21 a) along a direction where the distance from the central line in the axial direction of said columnar portion (21 a) to said outer surface of each of said projecting portions (21b) is increased when said columnar portion (21a) is inserted into said opening (51) of said circuit board (50).

9. The support member (20) of a circuit board (50) according to claim 2, wherein said columnar portion (21a) is formed in a hollow cylindrical shape, further comprising a pin member (22) suppressing deformation in a direction where an outer diameter of said columnar portion (21a) is reduced in a state where said columnar portion (21 a) is inserted into said opening (51) of said circuit board (50) by inserting said pin member along an inner circumferential surface of a hollow portion of said columnar portion (21a).

10. The support member (20) of a circuit board (50) according to claim 9, wherein
said columnar portion (21a) includes a first engaging portion (21e) formed on said inner circumferential surface of said hollow portion of said columnar portion (21a), said pin member includes a second engaging portion (22b) formed on an outer circumferential surface of a shaft portion extending in a longitudinal direction and engaging with said first engaging portion (21e), and
said second engaging portion (22b) of said pin member (22) is engaged with said first engaging portion (21e) of said columnar portion (21a) when said pin member (22) is inserted along said inner circumferential surface of said columnar portion (21a), so that said pin member (22) is inhibited from falling off said columnar portion (21 a).

11. The support member (20) of a circuit board (50) according to claim 10, wherein said first engaging portion (21e) is formed on a portion of said inner circumferential surface corresponding to an end region along the axial direction of said columnar portion (21 a).

12. The support member (20) of a circuit board (50) according to claim 10, wherein
said first engaging portion (21e) is formed by a recess portion where said inner circumferential surface of said columnar portion (21a) is concaved, and said second engaging portion (22b) is formed by a protruding portion where said shaft portion (22a) of said pin member (22) protrudes toward said recess portion, and
said first engaging portion (21e) is formed on a portion of said inner circumferential surface at a position corresponding to a projecting portion arranged on an end region along the axial direction of said columnar portion (21a) among said plurality of projecting portions (21b).

13. The support member (20) of a circuit board (50) according to claim 9, wherein said pin member (22) is so formed that a shaft portion (22a) is tapered toward a forward end side in a longitudinal direction.

14. The support member (20) of a circuit board (50) according to claim 13, wherein said columnar portion (21a) is so formed that an inner diameter of said hollow portion is reduced along the axial direction of said columnar portion (21 a) to correspond to the tapered shape of said pin member (22).

15. The support member (20) of a circuit board (50) according to claim 1, wherein
a step portion (21c, 21d) is formed between said outer circumferential surface of a portion between said projecting portions (21b), holding said circuit board (50), of said columnar portion (21a) and an outer surface of each of said projecting portions (21b), and
a surface (50b, 50c) of said circuit board (50) is in contact with said step portion in a state where said columnar portion (21a) is inserted into said opening (51) of said circuit board (50), so that said circuit board (50) is inhibited from falling off said columnar portion (21a).

## Patentansprüche

1. Trageelement (20) einer Leiterplatte (50), das umfasst:
einen säulenförmigen Abschnitt (21a), der in der Lage ist, eine Außenform durch elastische Verformung zu verkleinern, und in der Lage ist, durch eine Öffnung (51) hindurchzutreten, die an der Leiterplatte (50) vorhanden ist; und
eine Vielzahl vorspringender Abschnitte (21b), die so vorhanden sind, dass sie von einer Außenumfangsfläche des säulenförmigen Abschnitts (21a) vorstehen, in einem vorgeschriebenen Abstand (L2) in einer axialen Richtung des säulenförmigen Abschnitts (21 a) angeordnet sind und durch die Öffnung (51) der Leiterplatte (50) hindurchtreten, wenn der säulenförmige Abschnitt (21a) elastisch verformt wird und die Außenform verkleinert wird, und
wobei die Leiterplatte (50) zwischen den vorspringenden Abschnitten (21b), die in der axialen Richtung des säulenförmigen Abschnitts (21a) angrenzen, in einem Zustand angeordnet ist, in dem der säulenförmige Abschnitt (21a) durch die Öffnung (51) der Leiterplatte (50) hindurchtritt, so dass eine Vielzahl der Leiterplatten (50) in dem vorgeschriebenen Abstand (L2) entlang der axialen Richtung des säulenförmigen Abschnitts (21 a) gehalten werden,
**dadurch gekennzeichnet, dass**
jeder der Vorsprungsabschnitte (21b) in Umfangsrichtung an einer Außenumfangsfläche des säulenförmigen Abschnitts (21a) entlang ausgebildet ist, einen mit Flansch versehenen Absatzabschnitt (21c, 21d) zum Halten der Leiterplatte (50) aufweist und eine Außenfläche hat, die in der gleichen Richtung in Bezug auf die axiale Richtung des säulenförmigen Abschnitts (21a) geneigt ist.

2. Trageelement (20) einer Leiterplatte (50) nach Anspruch 1, das des Weiteren einen Schlitzabschnitt (23) zum Erleichtern elastischer Verformung des säulenförmigen Abschnitts (21a) umfasst, der an der Außenumfangsfläche des säulenförmigen Abschnitts (21a) in der axialen Richtung vorhanden ist.

3. Trageelement (20) einer Leiterplatte (50) nach Anspruch 2, wobei
der Schlitzabschnitt (23) so ausgebildet ist, dass er entlang der axialen Richtung durch einen vorgeschriebenen Bereich der Außenumfangsfläche des säulenförmigen Abschnitts (21a) hindurchverläuft, und der säulenförmige Abschnitt (21 a) in einer Richtung verformt wird, in der eine Breite (L3) des Schlitzabschnitts (23), der mit den vorspringenden Abschnitten (21b) versehenen Bereichen entspricht, verringert wird, so dass die vorspringenden Abschnitte (21b) durch die Öffnung (51) der Leiterplatte (50) hindurchtreten.

4. Trageelement (20) einer Leiterplatte (50) nach Anspruch 1, wobei jeder der vorspringenden Abschnitte (21b) so ausgebildet ist, dass eine Außenfläche, die von dem säulenförmigen Abschnitt (21a) vorsteht, in Draufsicht eine Kreisform hat, und
der säulenförmige Abschnitt (21a) durch die an der Leiterplatte (50) vorhandene Öffnung (51) hindurchtreten kann, wenn Außendurchmesser der kreisförmigen Außenflächen der vorspringenden Abschnitte (21b) verringert werden, wenn der säulenförmige Abschnitt (21 a) elastisch verformt wird, um die Außenform zu verkleinern.

5. Trageelement (20) einer Leiterplatte (50) nach Anspruch 2, wobei der Schlitzabschnitt (23) so ausgebildet ist, dass er in einer Richtung verläuft, die mit einer Achsenlinie zusammenfällt, ohne entlang der axialen Richtung geneigt zu sein, und er durch die Außenanfangsfläche hindurchverläuft.

6. Trageelement (20) einer Leiterplatte (50) nach Anspruch 2, wobei die Außenumfangsfläche des säulenförmigen Abschnitts (21a) mit Rückstellkraft zum Wiederherstellen der beim Einführen des säulenförmigen Abschnitts (21a) in die Öffnung (51) der Leiterplatte (50) verkleinerten Außenform zu einer ursprünglichen Größe durch elastische Verformung an eine Innenumfangsfläche der Öffnung (51) der Leiterplatte (50) gepresst wird, so dass der säulenförmige Abschnitt (21a) die Leiterplatte (50) an einem Abschnitt zwischen den vorstehenden Abschnitten (21b) des säulenförmigen Abschnitts (21a) hält.

7. Trageelement (20) einer Leiterplatte (50) nach Anspruch 4, wobei die vorspringenden Abschnitte (21b) in Umfangsrichtung an der Außenumfangsfläche des säulenförmigen Abschnitts (21a) entlang ausgebildet sind.

8. Trageelement (20) einer Leiterplatte (50) nach Anspruch 7, wobei
jeder der vorspringenden Abschnitte (21b) eine Außenform hat, durch die ein Abstand von einer Mittellinie in der axialen Richtung des säulenförmigen Abschnitts (21a) zu der Außenfläche des vorstehenden Abschnitts entlang der axialen Richtung des säulenförmigen Abschnitts (21a) verlängert wird, und
der säulenförmige Abschnitt (21a) so ausgebildet ist, dass er in die Öffnung (51) der Leiterplatte (50) in einem Zustand eingeführt wird, in dem die Außendurchmesser der vorspringenden Abschnitte (21b) durch das Aufsetzen der Leiterplatte (50) auf den säulenförmigen Abschnitt (21a) entlang einer Richtung elastisch verformbar verringert werden, in der der Abstand von der Mittellinie in der axialen Richtung des säulenförmigen Abschnitts (21a) zu der Außenfläche jedes der vorspringenden Abschnitte (21b) zunimmt, wenn der säulenförmige Abschnitt (21a) in die Öffnung (51) der Leiterplatte (50) eingeführt wird.

9. Trageelement (20) einer Leiterplatte nach Anspruch 2, wobei der säulenförmige Abschnitt (21a) in einer hohlen zylindrischen Form ausgebildet ist, und es des Weiteren ein Stiftelement (22) umfasst, das Verformung in einer Richtung verhindert, in der ein Außendurchmesser des säulenförmigen Abschnitts (21a) in einem Zustand verringert wird, in dem der säulenförmige Abschnitt (21a) in die Öffnung (51) der Leiterplatte (50) eingeführt wird, indem das Stiftelement entlang einer Innenumfangsfläche eines hohlen Abschnitts des säulenförmigen Abschnitts (21a) eingeführt wird.

10. Trageelement (20) einer Leiterplatte (50) nach Anspruch 9, wobei
der säulenförmige Abschnitt (21a) einen ersten Eingriffsabschnitt (21e) enthält, der an der Innenumfangsfläche des hohlen Abschnitts des säulenförmigen Abschnitts (21a) ausgebildet ist,
das Stiftelement einen zweiten Eingriffsabschnitt (22b) enthält, der an einer Außenumfangsfläche eines Schaftabschnitts ausgebildet ist, der in einer Längsrichtung verläuft, und mit dem ersten Eingriffsabschnitt (21e) in Eingriff kommt, und
der zweite Eingriffsabschnitt (22b) des Stiftelementes (22) mit dem ersten Eingriffsabschnitt (21e) des säulenförmigen Abschnitts (21a) in Eingriff kommt, wenn das Stiftelement (22) entlang der Innenumfangsfläche des säulenförmigen Abschnitts (21a) eingeführt wird, so dass verhindert wird, dass das Stiftelement (22) aus dem säulenförmigen Abschnitt (21a) herausfällt.

11. Trageelement (20) einer Leiterplatte (50) nach Anspruch 10, wobei der erste Eingriffsabschnitt (21e) an einem Abschnitt der Innenumfangsfläche ausgebildet ist, der einem Endbereich in der axialen Richtung des säulenförmigen Abschnitts (21a) entspricht.

12. Trageelement (20) einer Leiterplatte (50) nach Anspruch 10, wobei
der erste Eingriffsabschnitt (21e) durch einen Aussparungsabschnitt gebildet wird, in dem die Innenumfangsfläche des säulenförmigen Abschnitts (21a) konkav geformt ist, und der zweite Eingriffsabschnitt (22b) durch einen vorstehenden Abschnitt gebildet wird, in dem der Schaftabschnitt (22a) des Stiftelementes (22) auf den Aussparungsabschnitt zu vorsteht, und
der erste Eingriffsabschnitt (21e) an einem Abschnitt der Innenumfangsfläche an einer Position ausgebildet ist, die einem vorspringenden Abschnitt entspricht, der von der Vielzahl vorspringender Abschnitte (21b) an einem Endbereich in der axialen Richtung des säulenförmigen Abschnitts (21a) angeordnet ist.

13. Trageelement (20) einer Leiterplatte (50) nach Anspruch 9, wobei das Stiftelement (22) so ausgebildet ist, dass sich ein Schaftabschnitt (22a) zu einer vorderen Endseite in einer Längsrichtung hin verjüngt.

14. Trageelement (20) einer Leiterplatte (50) nach Anspruch 13, wobei der säulenförmige Abschnitt (21a) so ausgebildet ist, dass ein Innendurchmesser des hohlen Abschnitts entlang der axialen Richtung des säulenförmigen Abschnitts (21a) verringert wird, so dass er der sich verjüngenden Form des Stiftelementes (22) entspricht.

15. Trageelement (20) einer Leiterplatte (50) nach Anspruch 1, wobei
ein Absatzabschnitt (21c, 21d) zwischen der Außenumfangsfläche eines Abschnitts zwischen den vorspringenden Abschnitten (21b) des säulenförmigen Abschnitts (21e), die die Leiterplatte (50) halten, und einer Außenfläche jedes der vorspringenden Abschnitte (21b) ausgebildet ist, und
eine Fläche (50b, 50c) der Leiterplatte (50) in einem Zustand mit dem Absatzabschnitt in Kontakt ist, in dem der säulenförmige Abschnitt (21a) in die Öffnung (51) der Leiterplatte (50) eingeführt ist, so dass verhindert wird, dass die Leiterplatte (50) aus dem säulenförmigen Abschnitt (21) herausfällt.

## Revendications

1. Elément de support (20) d'une carte de circuit imprimé (50) comprenant:
une partie en forme de colonne (21a) apte à réduire une forme extérieure par déformation élastique et apte à passer à travers une ouverture (51) prévue sur la carte de circuit imprimé (50) ;
et
une pluralité de parties en saillie (21b) conçues de manière à faire saillie depuis une surface circonférentielle extérieure de ladite partie en forme de colonne (21a), disposées à un intervalle déterminé (L2) dans une direction axiale de ladite partie en forme de colonne (21a), et traversant ladite ouverture (51) de ladite carte de circuit imprimé (50) lorsque ladite partie en forme de colonne (21a) est déformée élastiquement afin de réduire ladite forme extérieure, et
ladite carte de circuit imprimé (50) est disposée entre lesdites parties en saillie (21b) de façon adjacente dans la direction axiale de ladite partie en forme de colonne (21a) dans un état dans lequel ladite partie en forme de colonne (21a) passe à travers ladite ouverture (51) de ladite carte de circuit imprimé (50), de sorte qu'une pluralité desdites cartes de circuit imprimé (50) est retenue au niveau dudit intervalle déterminé (L2) le long de la direction axiale de ladite partie en forme de colonne (21a),
**caractérisé en ce que**
chacune desdites parties en saillie (21b) est formée de manière circonférentielle le long d'une surface circonférentielle extérieure de ladite partie en forme de colonne (21a), comporte une partie gradin à rebord (21c, 21d) pour retenir ladite carte de circuit imprimé (50) et comporte une surface extérieure inclinée dans la même direction par rapport à la direction axiale de ladite partie en forme de colonne (21a).

2. Elément de support (20) d'une carte de circuit imprimé (50) conformément à la revendication 1, comprenant en outre une partie fendue (23) pour faciliter la déformation élastique de ladite partie en forme de colonne (21a), disposée sur la surface circonférentielle extérieure de ladite partie en forme de colonne (21a) le long de ladite direction axiale.

3. Elément de support (20) d'une carte de circuit imprimé (50) conformément à la revendication 2, dans lequel ladite partie fendue (23) est formée de manière à pénétrer dans une région déterminée de ladite surface circonférentielle extérieure de ladite partie en forme de colonne (21a) le long de ladite direction axiale, et ladite partie en forme de colonne (21a) est déformée dans une direction dans laquelle une largeur (L3) de ladite partie fendue (23) correspondant à des régions formées avec lesdites partie en saillie (21b) est réduite, de sorte que lesdites parties en saillie (21b) passent à travers ladite ouverture (51) de ladite carte de circuit imprimé (50).

4. Elément de support (20) d'une carte de circuit imprimé (50) conformément à la revendication 1, dans lequel chacune desdites parties en saillie (21b) est formée de sorte qu'une surface extérieure faisant saillie à partir de ladite partie en forme de colonne (21a) présente une forme circulaire dans une vue en plan, et il est permis à ladite partie en forme de colonne (21a) de passer à travers ladite ouverture (51) prévue sur ladite carte de circuit imprimé (50) par réduction des diamètres extérieures desdites surfaces extérieures circulaires desdites parties en saillie (21b) lorsque ladite partie en forme de colonne (21a) est déformée élastiquement afin de réduire ladite forme extérieure.

5. Elément de support (20) d'une carte de circuit imprimé (50) conformément à la revendication 2, dans lequel ladite partie fendue (23) est formée de manière à s'étendre dans une direction coïncidant avec une ligne d'axe sans s'incliner le long de ladite direction axiale et à pénétrer dans ladite surface circonférentielle extérieure.

6. Elément de support (20) d'une carte de circuit imprimé (50) conformément à la revendication 2, dans lequel ladite surface circonférentielle extérieure de ladite partie en forme de colonne (21a) est pressée sur une surface circonférentielle intérieure de ladite ouverture (51) de ladite carte de circuit imprimé (50) avec une force de restauration permettant de faire revenir ladite forme extérieure réduite par insertion de ladite partie en forme de colonne (21a) dans ladite ouverture (51) de ladite carte de circuit imprimé (50) à une taille d'origine par déformation élastique, de sorte que ladite partie en forme de colonne (21a) retient ladite carte de circuit imprimé (50) sur une partie entre lesdites parties en saillie (21b) de ladite partie en forme de colonne (21a).

7. Elément de support (20) d'une carte de circuit imprimé (50) conformément à la revendication 4, dans lequel lesdites parties en saillie (21b) sont formées de manière circonférentielle le long de ladite surface circonférentielle extérieure de ladite partie en forme de colonne (21a).

8. Elément formant support (20) d'une carte de circuit imprimé (50) conformément à la revendication 7, dans lequel chacune desdites parties en saillie (21b) présente une forme extérieure telle qu'une distance d'une ligne centrale dans la direction axiale de ladite partie en forme de colonne (21a) jusqu'à ladite surface extérieure de ladite partie en saillie augmente le long de la direction axiale de ladite partie en forme de colonne (21 a), et
ladite partie en forme de colonne (21a) est formée de manière à être introduite dans ladite ouverture (51) de ladite carte de circuit imprimé (50) dans un état dans lequel lesdits diamètres extérieurs desdites parties en saillie (21b) sont réduits par déformation élastique par adaptation de ladite carte de circuit imprimé (50) sur ladite partie en forme de colonne (21a) le long d'une direction dans laquelle la distance de la ligne centrale dans la direction axiale de ladite partie en forme de colonne (21a) à ladite surface extérieure de chacune desdites parties en saillie (21b) augmente lorsque ladite partie en forme de colonne (21a) est introduite dans ladite ouverture (51) de ladite carte de circuit imprimé (50).

9. Elément de support (20) d'une carte de circuit imprimé (50) conformément à la revendication 2, dans lequel ladite partie en forme de colonne (21a) est réalisée sous la forme d'un cylindre creux, comprenant en outre un élément tige (22) supprimant la déformation dans une direction dans laquelle un diamètre extérieur de ladite partie en forme de colonne (21 a) est réduit dans un état dans lequel ladite partie en forme de colonne (21a) est introduite dans ladite ouverture (51) de ladite carte de circuit imprimé (50) par introduction dudit élément tige le long d'une surface circonférentielle intérieure d'une partie creuse de ladite partie en forme de colonne (21 a).

10. Elément de support (20) d'une carte de circuit imprimé (50) conformément à la revendication 9, dans lequel ladite partie en forme de colonne (21a) comprend une première partie de coopération (21e) formée sur ladite surface circonférentielle intérieure de ladite partie creuse de ladite partie en forme de colonne (21a), ledit élément tige comprenant une seconde partie de coopération (22b) formée sur une surface circonférentielle extérieure d'une partie arbre s'étendant dans une direction longitudinale et coopérant avec ladite première partie de coopération (21 e), et
ladite seconde partie de coopération (22b) dudit élément tige (22) coopère avec ladite première partie de coopération (21e) de ladite partie en forme de colonne (21 a) lorsque ledit élément tige (22) est introduit le long de ladite surface circonférentielle intérieure de ladite partie en forme de colonne (21a), de sorte que ledit élément tige (22) est empêché de tomber de la partie en forme de colonne (21 a).

11. Elément de support (20) d'une carte de circuit imprimé (50) conformément à la revendication 10, dans lequel ladite première partie de coopération (21e) est formée sur une partie de ladite surface circonférentielle intérieure correspondant à une région d'extrémité le long de la direction axiale de ladite partie en forme de colonne (21 a).

12. Elément de support (20) d'une carte de circuit imprimé (50) conformément à la revendication 10, dans lequel ladite première partie de coopération (21e) est formée par une partie en retrait dans laquelle ladite surface circonférentielle intérieure de ladite partie en forme de colonne (21a) est concave, et ladite seconde partie de coopération (22b) est formée par une partie en saillie dans laquelle ladite partie arbre (22a) dudit élément tige (22) fait saillie vers ladite partie en retrait, et
ladite première partie de coopération (21e) est formée sur une partie de ladite surface circonférentielle intérieure en une position correspondant à une partie en saillie disposée sur une région d'extrémité le long de la direction axiale de ladite partie en forme de colonne (21a) parmi ladite pluralité de parties en saillie (21b).

13. Elément de support (20) d'une carte de circuit imprimé (50) conformément à la revendication 9, dans lequel ledit élément tige (22) est formé de manière à ce qu'une partie arbre (22a) est effilée vers un côté d'extrémité avant dans une direction longitudinale.

14. Elément de support (20) d'une carte de circuit imprimé (50) conformément à la revendication 13, dans lequel ladite partie en forme de colonne (21a) est formée de sorte qu'un diamètre intérieur de ladite partie creuse est réduite le long de la direction axiale de ladite partie en forme de colonne (21a) de manière à correspondre à la forme effilée dudit élément tige (22).

15. Elément de support (20) d'une carte de circuit imprimé (50) conformément à la revendication 1, dans lequel une partie gradin (21c, 21d) est formée entre ladite surface circonférentielle extérieure d'une partie entre lesdites parties en saillie (21 b), retenant ladite carte de circuit imprimé (50), de ladite partie en forme de colonne (21a) et une surface extérieure de chacune desdites parties en saillie (21 b), et
une surface (50b, 50c) de ladite carte de circuit imprimé (50) est en contact avec ladite partie gradin dans un état dans lequel ladite partie en forme de colonne (21 a) est introduite dans ladite ouverture (51) de ladite carte de circuit imprimé (50), de sorte que la carte de circuit imprimé (50) est empêchée de tomber de ladite partie en forme de colonne (21 a).
